# EUROPEAN PATENT APPLICATION

(11) **EP 4 538 719 A1**
(43) Date of publication of application: **16.04.2025**
(21) Application number: 23202608.8
(22) Date of filing: 10.10.2023
(51) Int. Cl.: G01R 15/18

(54) **CURRENT DETECTION DEVICE FOR ELECTRICAL INSTALLATIONS**

(71) Applicant: ABB Schweiz AG, 5400 Baden (CH)
(72) Inventor: JABLONSKI, Mateusz, 30-322 Krakow (PL); ZAWADZKI, Artur, 30-684 Krakow (PL); PIASECKI, Wojciech, 31-347 Krakow (PL); NOVELLO, Noemi, 20039 Canegrate (IT)
(74) Representative: De Bortoli, Eros

(57) **Abstract**

A current detection device comprising:
- a support board having opposite first and second surfaces and a passage for a conductor of an electric line through the thickness of the support board between the first and second surfaces of the support board;
- a plurality of conductive coils arranged on at least one of said first and second surfaces of the support board at corresponding coil regions of the support board. Each conductive coil is formed by at least a coil turn wound around a corresponding coil axis perpendicular to said support board and extending planarly along one of the first and second surfaces of the support board;
- a magnetic circuit including a plurality of magnetic elements and a plurality of airgaps. The magnetic elements of the magnetic circuit are arranged on both the first and second surfaces of the support board.

Each magnetic element extends in parallel to a surface of the support board and is overlapped, at two or more coil regions of the support board, with another magnetic element arranged at the opposite surface of the support board.

A pair of overlapped magnetic elements spaced apart one from another by the thickness of the support board is thus formed at each coil region. Each pair of overlapped and spaced apart magnetic elements defines an airgap of said magnetic circuit, in which a conductive coil is placed.

## Description

The present invention relates to a current detection device for electrical installations, for example low-voltage electrical switchboards or electric lines.

As widely known, measurement systems for low-voltage electrical installations frequently employ detection devices operating as current transformers to detect an AC current flowing along electrical conductors.

More traditional devices of this type are relatively simple to manufacture at industrial level and ensure good performances in terms of detection accuracy. However, due to their cumbersome structure, they may be relatively difficult to install on the field, particularly in the electrical installations where multiple current detection points are needed or small installation spaces are available.

In the attempt of overcoming these problems, current detection devices realized through printed circuit manufacturing techniques have been developed in the recent years. Examples of these current detection devices are described in US6313623B1 and US11322297B2. Available solutions of this type have still some aspects to improve, particularly in relation to their manufacturability at industrial level and easiness of installation on the field.

The main aim of the present invention is to provide a current detection device for low-voltage electrical installations, which allows overcoming or mitigating the mentioned technical problems of the state of the art.

Within the scope of this aim, an object of the present invention is to provide a current detection device ensuring relatively high performances in terms of detection accuracy and linearity for a wide range of amplitudes of currents to be measured.

Another object of the present invention is to provide a current detection device having a very compact size and light weight.

Another object of the present invention is to provide a current detection device particularly adapted for being manufactured industrially, at very competitive costs with similar devices of the state of the art.

This aim, these objects and others which will become apparent hereinafter are achieved by a current detection device according to the following claim 1 and the related dependent claims. In a general definition, the current detection device, according to the invention, comprises:
- a support board having opposite first and second surfaces and a passage for a conductor of an electric line through the thickness of said support board between said first and second surfaces;
- a plurality of conductive coils, each arranged at a corresponding coil region of the support board. Each conductive coil is formed by at least a coil turn wound around a corresponding coil axis perpendicular to said support board and extending planarly along at a coil surface of the support board. Such a coil surface may be one of the first and second surfaces of said support board. Alternatively, said coil surface may be an internal surface of said support board, which is placed between the first and second surfaces of said support board;
- a magnetic circuit including a plurality of magnetic elements and a plurality of airgaps. According to some embodiments of the invention, the current detection device may include multiple conductive coils arranged on corresponding multiple coil surfaces at a same coil region. The surfaces of the support board, which form the multiple coil surfaces for the multiple conductive coils arranged at a same coil region, may include both the opposite first and second surfaces of the support board, or at least one of the opposite first and second surfaces of the support board and at least one internal surface of the support board or a plurality of internal surfaces of the support board.

The magnetic elements of said magnetic circuit are arranged on both the first and second surfaces of the support board. Each magnetic element extends in parallel to a surface of the support board and is overlapped, at two or more coil regions of the support board, with another opposite magnetic element arranged at the opposite surface of the support board.

A pair of overlapped magnetic elements spaced apart one from another by the thickness of the support board is thus formed at each coil region of the support board.

Each pair of overlapped and spaced apart magnetic elements defines an airgap of the magnetic circuit. Each conductive coil is placed in a corresponding airgap of the magnetic circuit.

According to an aspect of the invention, each conductive coil is formed by at least a coil turn spirally wound around a corresponding coil axis perpendicular to the support board.

According to an aspect of the invention, each conductive coil is formed by at least a conductive route deposited on a coil surface of the support board by means of printed circuit technologies. According to an aspect of the invention, each magnetic element is shaped in such a way to surround partially the passage through the support board at a surface of the support board.

According to an aspect of the invention, the coil regions on the support board are arranged at symmetric positions relative to the passage through said support board.

According to an aspect of the invention, each magnetic element is formed by at least a plate made of a ferromagnetic material.

Preferably, each magnetic element is formed by a single contoured plate made of a ferromagnetic material.

According to alternative embodiments, however, each magnetic element may be formed by a stack of contoured plates made of a ferromagnetic material.

The present invention relates also to a current measurement unit, according to the following claim 13 and the related dependent claims.

Further characteristics and advantages of the invention will become apparent from the description of preferred but not exclusive embodiments of the current detection device according to the invention, illustrated only by way of non-limitative example in the accompanying drawings, wherein:
- figures 1-2 are schematic views of an embodiment of the current detection device, according to the invention;
- figures 3-4 are schematic views of another embodiment of the current detection device, according to the invention;
- figure 5, 5A, 5B are schematic views of a coil region according to some embodiments of the current detection device, according to the invention;
- figure 6 is a schematic view of a conductive coil included in the current detection device, according to the invention;
- figure 7 schematically shows the behaviour of the current detection device, according to the invention;
- figures 8-9 are schematic views of a measurement unit including the current detection device, according to the invention.

With reference to the above cited figures, the present invention relates to a current detection device 1 for detecting an AC current flowing along a conductor 100.

The current detection device 1 is suitable for installation in electric lines or electrical switchboards, preferably operating at a low-voltage or medium-voltage levels.

According to the invention, the circuit detection device 1 comprises a support board 2 having opposite first and second surfaces 21, 22 that advantageously extend along parallel reference planes.

Preferably, the support board 2 has a planar geometry and the opposite first and second surfaces 21, 22 are the surfaces defining the thickness of the support board.

Preferably, the support board 2 is a circuit printed board (PCB) and the opposite first and second surfaces 21, 22 are the mounting surfaces of the PCB where electronic components are normally arranged.

The support board 2 comprises a passage 20 for a conductor 100. Such a passage is conveniently formed by a hole extending through the thickness of the support board between the first and second surfaces 21, 22.

When the current detection device 1 is installed on the field, the conductor 100, along which it flows the current to be monitored, is inserted through the passage 20 of the support board (as shown in the cited figures). Preferably, the support board 2 is positioned perpendicularly to the conductor 100, when this latter is inserted through the passage 20.

According to the invention, the circuit detection device 1 comprises a plurality of conductive coils 3a, 3b, 3c, 3d arranged at corresponding coil regions 2a, 2b, 2c, 2d of the support board. The coil regions 2a, 2b, 2c, 2d are preferably placed around the passage 20, more preferably at symmetric positions relative to this latter.

In general terms, the conductive coils 3a, 3b, 3c, 3d are arranged on corresponding coil surfaces of the support board.

A coil surface may be one of the first and second surfaces 21, 22 or an internal surface 25 of the support board, which is arranged between the opposite first and second surfaces 21, 22.

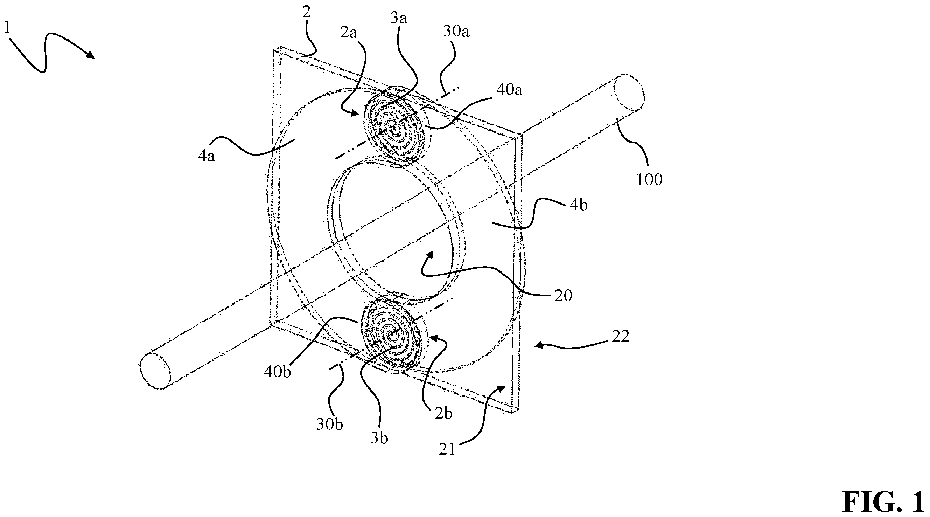

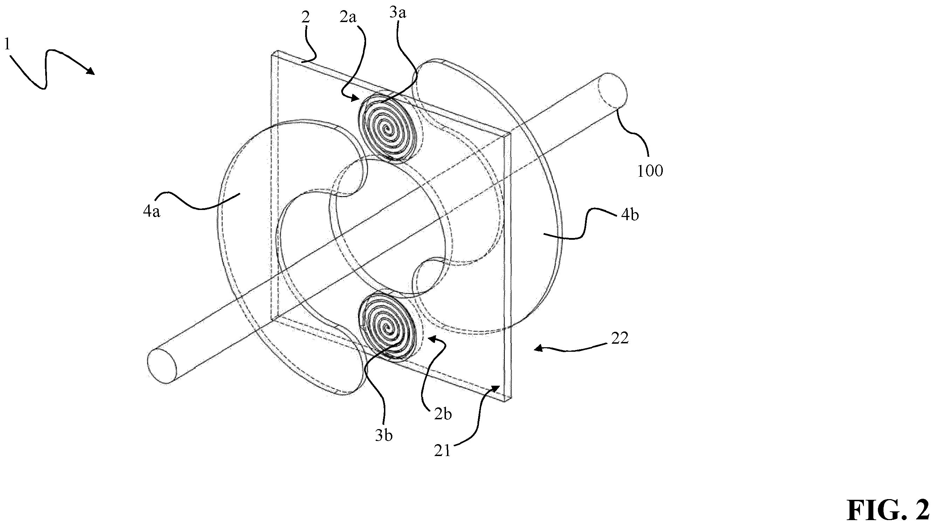

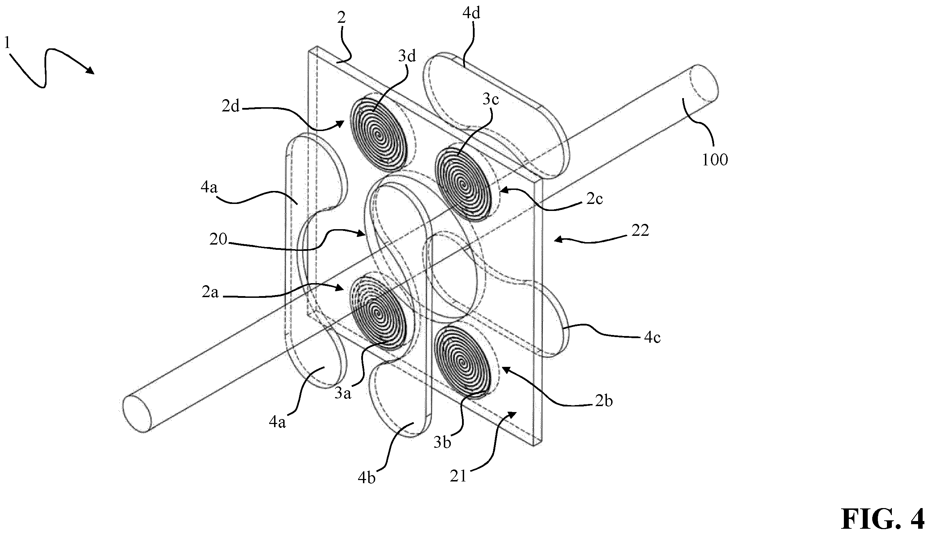

Figures 1-5 show embodiments of the invention, in which the conductive coils 3a, 3b, 3c, 3d are arranged on the first surface 21 of the support board.

According to alternative embodiments (not shown), however, the conductive coils 3a, 3b, 3c, 3d may be arranged on the second surface 22 of the support board.

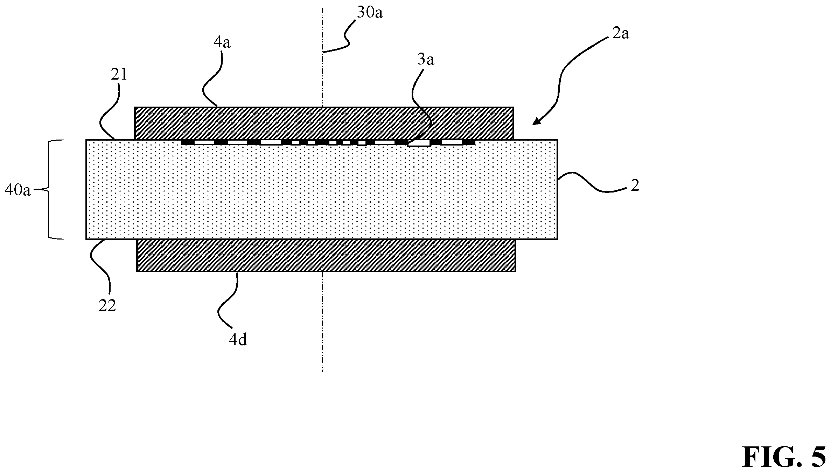

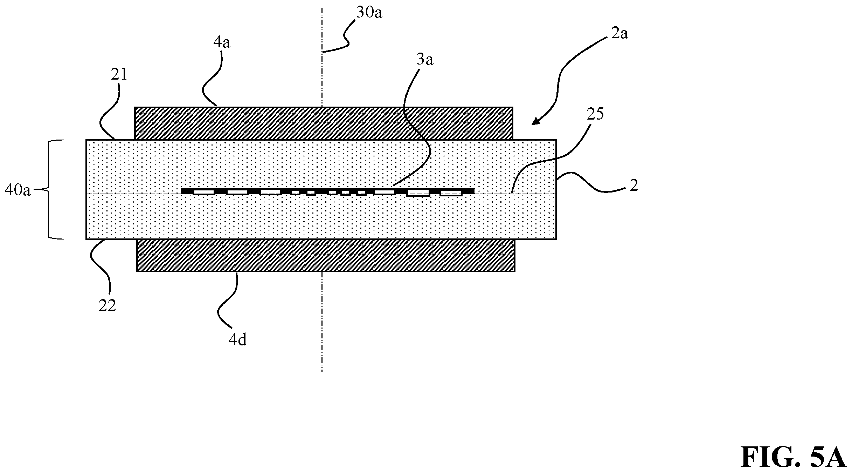

Figure 5A shows an embodiment of the invention, in which a generic coil 3a is arranged on an internal coil surface 25 of the support board between the opposite first and second surfaces 21, 22 of the support board.

In general, the conductive coils 3a, 3b, 3c, 3d may be arranged on a same coil surface as shown in figures 1-5. However, the conductive coils may be arranged also on different coil surfaces. For example, one coil may be arranged on the first surface 21 of the support board while another coil may be arranged on the second surface 22 of the support board.

Figures 1-5 show embodiments of the invention, in which a single conductive coil 3a, 3b, 3c, 3d is arranged for each coil region.

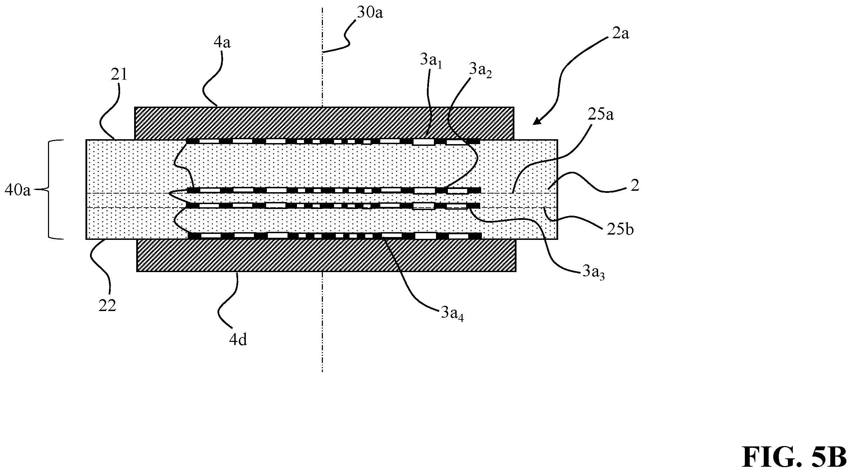

According to other embodiments of the invention (figure 5B), multiple conductive coils may be arranged on corresponding multiple coil surfaces at a same coil region. In this case, the multiple conductive coils arranged at a same corresponding coil region of the support board are preferably electrically connected in series.

In general terms, according to these embodiments of the invention, the surfaces of the support board, which form the multiple coil surfaces for the multiple conductive coils arranged at a same coil region, may include both the opposite first and second surfaces 21, 22 of the support board, or at least one of the opposite first and second surfaces 21, 22 of the support board and at least one internal surface 25 of the support board or a plurality of internal surfaces 25 of the support board.

Figure 5B shows an embodiment of the invention, in which multiple conductive coils 3ai, 3a₂, 3as, 3a₄ are arranged at a same coil region 2a of the support board. The conductive coils are arranged on the opposite first and second surfaces 21, 22 of the support board and on a plurality of internal surfaces 25a, 25b of the support board.

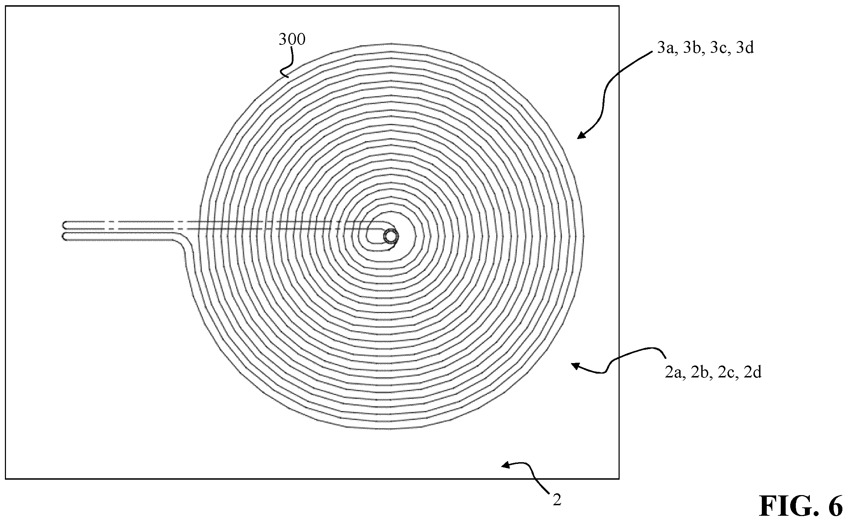

Each conductive coil 3a, 3b, 3c, 3d includes at least a coil turn 30 wound around a corresponding coil axis 30a, 30b, 30c, 30d perpendicular to the support board (figures 1, 3, 5, 6). Each coil turn 30 extends planarly along a corresponding coil surface 21, 22, 25 of the support board in such a way to define a surface portion enchaining a magnetic flux directed perpendicularly to it (figure 6).

Preferably, each conductive coil 3a, 3b, 3c, 3d is formed by depositing one or more conductive routes on a corresponding coil surface of the support board through suitable printed circuit technologies, which may be of known type.

Preferably, for each conductive coil 3a, 3b, 3c, 3d, the deposited conductive routes are designed in such a way to define one or more coil turns 30 having the layout described above.

Figure 6 shows a generic conductive coil 3a, 3b, 3c, 3d according to a possible embodiment of the invention. In this case, the conductive coil 3a, 3b, 3c, 3d includes a single coil turn 30 spirally wound around a corresponding coil axis 30a, 30b, 30c, 30d perpendicular to the support board 3. As it is possible to notice, the conductive coil 3a, 3b, 3c, 3d may be formed by depositing a conductive route 300 on a coil surface of the support board at a corresponding coil region 2a, 2b, 2c, 2d. The geometry of the conductive route 300 is designed in such a way to form the spirally wound coil 30.

The above-described special arrangements for the conductive coil 3a, 3b, 3c, 3d are quite advantageous as they allow remarkably reducing the manufacturing costs of the current detection device. As a matter of fact, differently from available solutions of the state of the art, the sensing components of the current detection device (the conductive coils 3a, 3b, 3c, 3d) may be industrially manufactured on a standard PCB, where suitable planar conductive routes may be formed by using two-dimensional printed circuit technologies. Apparently, this greatly simplifies the overall manufacturing process of the current detection device.

According to the invention, the circuit detection device 1 comprises a magnetic circuit including a plurality of magnetic elements 4a, 4b, 4c, 4d and a plurality of airgaps 40a, 40b, 40c, 40d.

The magnetic elements 4a, 4b, 4c, 4d are arranged on both the opposite first and second surfaces 21, 22 of the support board. To this aim, each magnetic element may be fixed on a corresponding surface 21, 22 through suitable gluing, soldering or riveting techniques. Preferably, each magnetic element 4a, 4b, 4c, 4d is formed by at least a plate made of a ferromagnetic material.

In the embodiments shown in the cited figures, each magnetic element 4a, 4b, 4c, 4d is formed by a single contoured plate of ferromagnetic material.

According to alternative embodiments (not shown), however, a magnetic element may be formed by a stack of contoured plates made of a ferromagnetic material, which are overlapped one on another. In this case, the overlapped plates may be joined one on another through suitable soldering or gluing techniques.

Each magnetic element 4a, 4b, 4c, 4d extends in parallel to the respective surface 21, 22 of the support board, on which it is arranged.

The magnetic elements 4a, 4b, 4c, 4d may have various shapes according to the needs. Preferably, each magnetic element is shaped in such a way to surround partially the passage 20 at a surface 21, 22 of the support board.

At two or more coil regions 2a, 2b, 2c, 2d of the support board, each magnetic element 4a, 4b, 4c, 4d is overlapped with another magnetic element arranged at the opposite surface of the support board. In this way, a pair of overlapped magnetic elements 4a, 4b, 4c, 4d, which are spaced apart one from another by the thickness of the support board, is formed at each coil region 2a, 2b, 2c, 2d of the support board.

Each pair of overlapped and spaced apart magnetic elements 4a, 4b, 4c, 4d defines a corresponding airgap 40a, 40b, 40c, 40d of the magnetic circuit.

Each conductive coil 3a, 3b, 3c, 3d is placed in a corresponding airgap 40a, 40b, 40c, 40d of the magnetic circuit.

The cited figures show embodiments of the invention in which a conductive coil 3a, 3b, 3c, 3d is arranged in each airgap 40a, 40b, 40c, 40d of the magnetic circuit.

In some cases, however, one or more airgaps of the magnetic circuit may include no conductive coils placed therein.

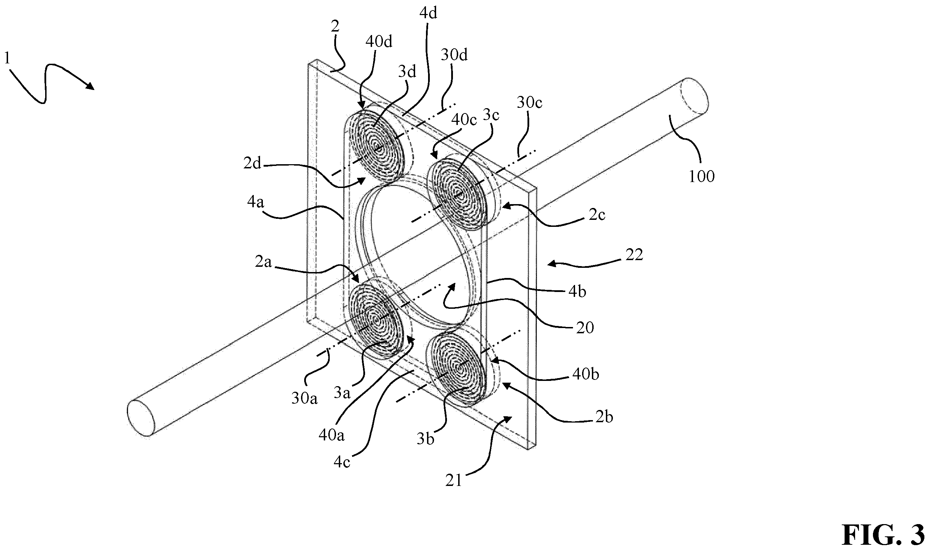

Figure 5 shows a cross-section of the current detection device 1, according to the embodiment of figures 3-4, at the coil region 2a of the support board. The overlapped magnetic elements 4a, 4c are spaced apart by the thickness of the support board 2 and define a corresponding airgap 40a of the magnetic circuit of the current detection device.

A conductive coil 3a is arranged on the first surface 21 at the coil region 2a. The conductive coil 3a is therefore placed in the airgap 40a formed by the opposite overlapped magnetic elements 4a, 4c.

Figure 5A shows a cross-section of the current detection device, according to an alternative embodiment of the invention, at the same coil region 2a of the support board. In this case, the conductive coil 3a is arranged on an internal surface 25 between the first and second surfaces 21, 22 of the support board at the coil region 2a. The conductive coil 3a is thus buried in the thickness of the support board. Nonetheless, it is placed in the airgap 40a formed by the opposite overlapped magnetic elements 4a, 4c.

Figure 5B shows an embodiment of the invention, in which multiple conductive coils 3ai, 3a₂, 3as, 3a₄ are arranged at a same coil region 2a of the support board. Conductive coils 3ai, 3a₄ are located at corresponding coil surfaces formed by the opposite first and second surfaces 21, 22 of the support board while coils 3a₂, 3a₃ are located at corresponding internal surfaces 25a, 25b of the support board between the opposite first and second surfaces 21, 22 of the support board. The conductive coils 3ai, 3a₂, 3as, 3a₄ of the coil region 2a are electrically connected in series.

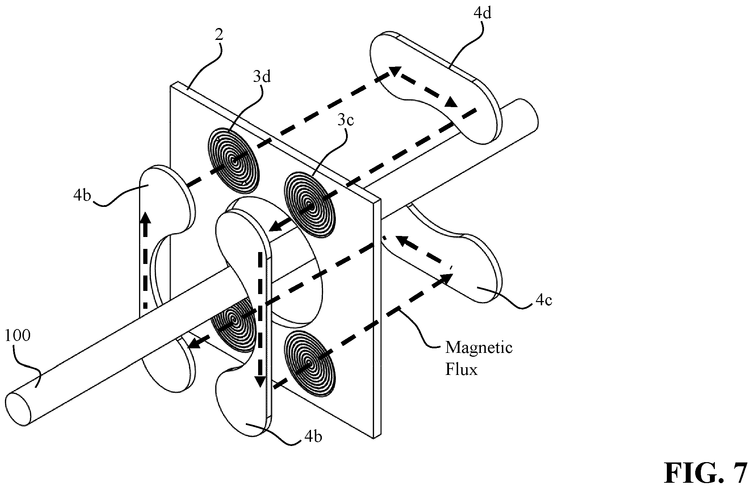

Figure 7 shows the operation of the current detection device 1, according to the embodiment of figures 3-4.

A current to be monitored flows along the conductor 100 inserted through the passage 20 of the support board 2 and it generates a magnetic flux directed perpendicularly to the flow direction of the current.

The magnetic circuit of the current detection deviates such a magnetic flux and conveys it along a three-dimensional closed path around the support 2 and passing through this latter.

Each magnetic element 4a, 4b, 4c, 4d operates, in fact, as a magnetic flux concentrator and it conveys the magnetic flux generated by the current to be monitored along a corresponding direction parallel to the surface 21, 22 of the support board, where said magnetic element is arranged.

At each coil region 2a, 2b, 2c, 2d of the support board, each magnetic element 4a, 4b, 4c, 4d is overlapped with another magnetic element arranged at the opposite surface of the support board, thereby defining a corresponding airgap 40a, 40b, 40c, 40d.

Each pair of overlapped magnetic elements 4a, 4b, 4c, 4d thus conveys the magnetic flux along a corresponding direction perpendicular to the support board 2 in such a way that such a magnetic flux passes though the thickness of the support board 2 at the corresponding airgap 40a, 40b, 40c, 40d.

At each airgap 40a, 40b, 40c, 40d, the magnetic flux enchains with a corresponding conductive coil 3a, 3b, 3c, 3d placed in said airgap.

Each conductive coil 3a, 3b, 3c, 3d can thus provide in output a signal (preferably a voltage signal) indicative of the enchained magnetic flux, which is in turn proportional to the current to be monitored.

It is apparent how the special arrangement provided for the conductive coils 3a, 3b, 3c, 3d and the magnetic elements 4a, 4b, 4c, 4d allows the current detection device, according to the invention, to operate as a current transformer even if its structure is substantially bidimensional as explained above.

As a matter of fact, in operation, the current detection device 1 includes:
- a magnetic circuit formed by the magnetic elements 4a, 4b, 4c, 4d and configured to concentrate the magnetic flux generated by the current to be monitored;
- a primary winding coupled to said magnetic circuit and formed by the conductor 100, on which the current to be monitored flows;
- a plurality of secondary windings coupled to said magnetic circuit and formed by the conductive coils 3a, 3b, 3c, 3d that are configured to enchain the magnetic flux flowing along the magnetic circuit.

The current detection device can thus ensure high level detection capabilities and, at the same time, have a compact size. Additionally, the current detection device proves to be relatively easy to manufacture at industrial level as it may be arranged through well-established printed circuit technologies of planar type.

Figures 1-2 show an exemplary embodiment of the current detection device according to the invention.

The current detection device comprises first and second conductive coils 3a, 3b arranged on the support board 2 at corresponding first and second coil regions 2a, 2b, which are symmetrically placed in opposite positions related to the passage 20 through the support board. Each conductive coil 3a, 3b includes a single coil turn spirally wound around a corresponding axis 30a, 30b perpendicular to the support board and formed by suitable conductive routes deposited on the first surface 21 of the support board (figure 6).

The conductive coils 2a, 2b are electrically disconnected one from another. In operation, each conductive coil will therefore provide an output signal indicative of the magnetic flux circulating along the magnetic circuit and enchained with said conductive coil.

The current detection device comprises a magnetic circuit including first and second magnetic elements 4a, 4b and first and second airgaps 40a, 40b at the coil regions 2a, 2b, respectively. The first and second magnetic elements 4a, 4b are arranged on the opposite first and second surfaces 21, 22 of the support board.

Each magnetic element 4a, 4b is formed by a contoured plate of ferromagnetic material.

At the coil regions 2a, 2b of the support board, the opposite magnetic elements 4a, 4b are mutually overlapped and spaced apart by the thickness of the support board.

Each magnetic element 4a, 4b has a semi-circular shape to surround the passage 20 through the circuit board and it extends between the coil regions 2a, 2b of the support board, at which the opposite ends of the magnetic element are overlapped with the opposite ends of the other magnetic element.

The overlapped magnetic elements 4a, 4b at the first coil region 2a define a first airgap 40a of the magnetic circuit, in which the first conductive coil 3a is placed.

The overlapped magnetic elements 4a, 4b at the second coil region 2b define a second airgap 40b of the magnetic circuit, in which the second conductive coil 3b is placed.

The operation of this embodiment of the current detection device is substantially identical to what explained above with reference to figure 7.

The only difference consists in the different shape of the magnetic circuit formed by the magnetic elements of the current detection device.

The magnetic circuit formed by the magnetic elements 4a, 4b conveys the magnetic flux generated by the current to be monitored (which flows along the conductor 100) along a three-dimensional closed path having semicircular portions extending along the opposite surfaces 21, 22 and passing through the thickness of the support board 2 at the coil regions 2a, 2b where the conductive coils 3a, 3b are placed at the airgaps 40a, 40b.

Figures 3-4 show another exemplary embodiment of the current detection device according to the invention.

The current detection device comprises first, second, third and fourth conductive coils 3a, 3b, 3c, 3d arranged on the support board 2 at corresponding first, second, third and fourth coil regions 2a, 2b, 2c, 2d of the support board, which are symmetrically placed around the passage 20 through the support board.

Each conductive coil 3a, 3b, 3c, 3d includes a single coil turn spirally wound around a corresponding axis 30a, 30b, 30c, 30d perpendicular to the support board and are formed by suitable conductive routes deposited on the first surface 21 of the support board (figure 6).

The first and second conductive coils 3a, 3b are electrically connected in series as well as the third and fourth conductive coils 3a, 3b. In operation, each pair of electrically connected conductive coils will thus provide an output signal (preferably a voltage signal) indicative of the magnetic flux circulating along the magnetic circuit and enchained with said conductive coils.

The current detection device comprises a magnetic circuit including first, second, third and fourth magnetic elements 4a, 4b, 4c, 4d and first, second, third and fourth airgaps 40a, 40b, 40c, 40d at the coil regions 2a, 2b, 2c, 2d of the support board, respectively.

The magnetic circuit has the first and second magnetic elements 4a, 4b arranged at the first surface 21 of the support board and the third and fourth magnetic elements 4c, 4d arranged at the opposite second surface 22 of the support board.

Each magnetic element 4a, 4b, 4c, 4d is formed by a contoured plate of ferromagnetic material. Each magnetic element 4a, 4b has a rectilinear shape that is contoured to surround the passage 20 through the circuit board.

The first magnetic element 4a extends between the first and fourth coil regions 2a, 2d of the support board, the second magnetic element 4b extends between the second and third coil regions 2b, 2c of the support board, the third magnetic element 4c extends between the first and second coil regions 2a, 2b of the support board while the fourth magnetic element 4d extends between the third and fourth coil regions 2c, 2d of the support board.

At the first and fourth coil regions 2a, 2d of the support board, the first magnetic element 4a is overlapped with the third and fourth magnetic elements 4c, 4d and spaced apart from these latter by the thickness of the support board.

At the second and third coil regions 2b, 2c of the support board, the second magnetic element 4b is overlapped with the third and fourth magnetic elements 4c, 4d and spaced apart from these latter by the thickness of the support board.

Symmetrically, at the first and second coil regions 2a, 2b of the support board, the third magnetic element 4c is overlapped with the first and second magnetic elements 4a, 4b and spaced apart from these latter by the thickness of the support board, while, at the third and fourth coil regions 2c, 2d of the support board, the fourth magnetic element 4d is overlapped with the first and second magnetic elements 4a, 4b and spaced apart from these latter by the thickness of the support board.

The overlapped first and third magnetic elements 4a, 4c at the first coil region 2a of the support board define the first airgap 40a of the magnetic circuit, in which the first conductive coil 3a is placed.

The overlapped second and third magnetic elements 4b, 4c at the second coil region 2b of the support board define the second airgap 40b of the magnetic circuit, in which the second conductive coil 3b is placed.

The overlapped second and fourth magnetic elements 4a, 4d at the third coil region 2c of the support board define the third airgap 40c of the magnetic circuit, in which the third conductive coil 3c is placed.

The overlapped first and fourth magnetic elements 4a, 4d at the fourth coil region 2d of the support board define the fourth airgap 40d of the magnetic circuit, in which the fourth conductive coil 3d is placed.

The operation of this embodiment of the current detection device is identical to what explained above with reference to figure 7.

The magnetic circuit formed by the magnetic elements 4a, 4b, 4c, 4d conveys the magnetic flux generated by the current flowing along the conductor 100 along a three-dimensional closed path, which has pairs of rectilinear portions extending along both the opposite surfaces 21, 22 and passes through the thickness of the support board at the coil regions 2a, 2b, 2c, 2d where the conductive coils 3a, 3b, 3c, 3d are placed at the airgaps 40a, 40b, 40c, 40d.

As the skilled person will certainly understand, different arrangements of the current detection device are possible according to the needs.

For example, the current detection device may include a magnetic circuit having a different number of magnetic elements and airgaps and/or having magnetic elements shaped differently to build a magnetic path having a different geometry.

As another example, the current detection device may include a different number of conductive coils or differently connected electrically one to another.

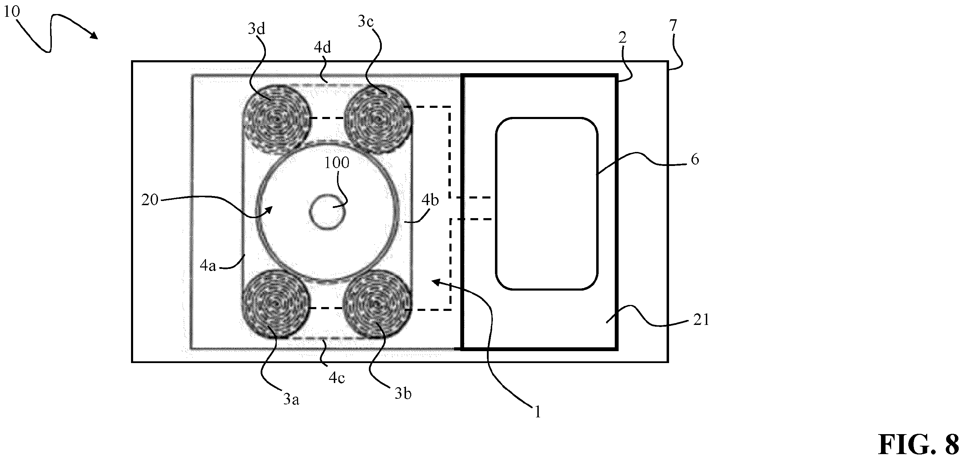

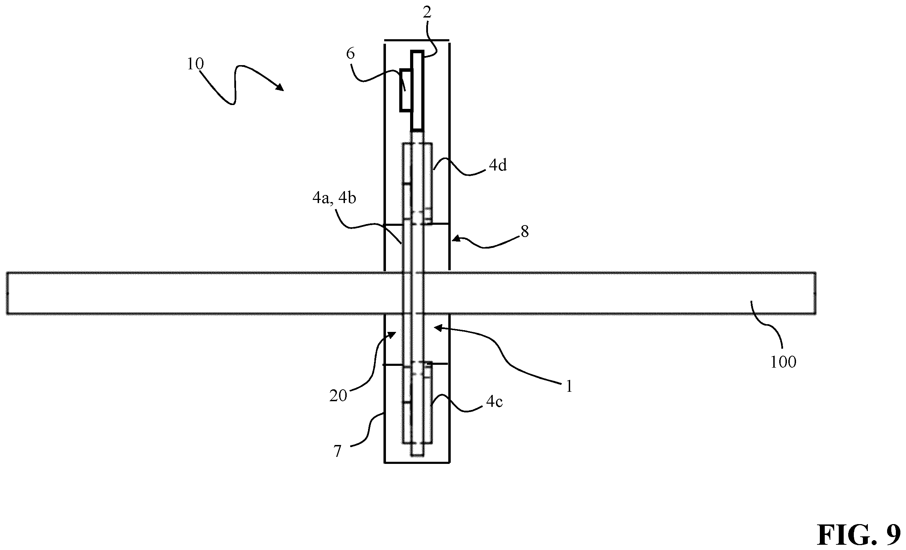

Figures 8-9 shows a measuring unit 10 for low-voltage applications including the current detection device according to the invention.

The measuring unit 10 may be installed as a stand-alone device or incorporated in another electrical apparatus or measurement system.

For example, an industrial circuit breaker may incorporate a plurality of measuring units 10 at its electric poles to detect AC currents flowing along the electric phases of an electric line. As a further example, an energy metering system may include multiple measuring units 10 to detect AC currents flowing along the electric branches of an electric grid and provide local detection data to a central data processing unit.

Preferably, the measuring unit 10 comprises an outer enclosure 7 having a pass-through aperture 8 for the insertion of a conductor 100, on which flows a current to be monitored.

The enclosure 7 defines an internal volume, in which the current detection device 1 is accommodated in such a way that the passage 20 through the support board 2 is aligned with the pass-through aperture 8 of the enclosure 7.

Preferably, the measuring unit 10 includes a signal processing device 6 accommodated in the internal volume of the enclosure 7 and electrically connected to the conductive coils 3a, 3b, 3c, 3d of the current detection device to receive and process detection signals (preferably voltage signals) indicative of a magnetic flux enchained with said conductive coils.

The signal processing device 6 may be of analog type. In this case, it may include a suitable ASIC unit configured to carry out the requested signal processing functions.

As an alternative, the signal processing device 6 may be of digital type. In this case, it may include a suitable data processing unit (e.g., including a microprocessor) capable of executing software instructions stored in memory and configured to implement the requested signal processing functions, when executed by said data processing unit.

Preferably, the signal processing device 6 is arranged on a dedicated section of the support board 2 of the current detection device 1. This allows simplifying the manufacturing process of the manufacturing unit 10.

It has been found that the current detection device according to the invention achieves the intended aim and objects.

As mentioned above, the current detection device of the invention substantially operates as a current transformer even if its structure is basically planar.

The magnetic circuit formed by the magnetic elements 4a, 4b, 4c, 4d allows maximizing the magnetic flux enchained with the conductive coils 3a, 3b, 3c, 3d even if the support board 2 (on the surfaces 21, 22 of which the conductive coils are realized) has a planar geometry and is oriented perpendicularly to the conductor 100, when this latter is inserted through the passage 20.

The current detection device of the invention thus ensures high level performances in terms of detection accuracy and linearity for a wide range of amplitudes of currents to be measured.

At the same time, by virtue of its planar structure, the current detection device of the invention has a very small size (e.g., with a thickness of few mm) and light weight, which remarkably facilitates its use in electrical installations, particularly where multiple current detection points are needed or small installation spaces are available.

Further, always thanks to its planar structure, the current detection device of the invention is particularly adapted for being manufactured by means of two-dimensional printed circuit technologies. The current detection device is thus very simple and very cheap to manufacture at industrial level.

## Claims

1. A current detection device (1) for electrical installations **characterized in that** it comprises:
- a support board (2) having opposite first and second surfaces (21, 22) and a passage (20) for a conductor (100) of an electric line through a thickness of said support board between the first and second surfaces (21, 22) of said support board;
- a plurality of conductive coils (3a, 3b, 3c, 3d) arranged at corresponding coil regions (2a, 2b, 2c, 2d) of said support board,
wherein each conductive coil is formed by at least a coil turn (30) wound around a coil axis (30a, 30b, 30c, 30d) perpendicular to said support board and extending planarly along a coil surface (21, 22, 25) of said support board;
- a magnetic circuit including a plurality of magnetic elements (4a, 4b, 4c, 4d) and a plurality of airgaps (40a, 40b, 40c, 40d),
wherein said magnetic elements (4a, 4b, 4c, 4d) are arranged on both the surfaces (21, 22) of said support board,
wherein each magnetic element (4a, 4b, 4c, 4d) extends in parallel to a surface (21, 22) of said support board and is overlapped, at two or more coil regions (2a, 2b, 2c, 2d) of said support board, with another magnetic element arranged at the opposite surface (21, 22) of said support board,
wherein a pair of overlapped magnetic elements (4a, 4b, 4c, 4d) spaced apart one from another by the thickness of said support board is formed at each coil region (2a, 2b, 2c, 2d),
wherein each pair of overlapped and spaced apart magnetic elements (4a, 4b, 4c, 4d) defines an airgap (40a, 40b, 40c, 40d,) of said magnetic circuit,
wherein each conductive coil (3a, 3b, 3c, 3d) is placed in an airgap (40a, 40b, 40c, 40d,) of said magnetic circuit.

2. Current detection device, according to claim 1, **characterised in that** said coil surface (21, 22) is formed by one of the first and second surfaces (21, 22) of said support board.

3. Current detection device, according to one of the previous claims, **characterised in that** said coil surface is formed by an internal surface (25) of said support board between the first and second surfaces (21, 22) of said support board.

4. Current detection device, according to one of the previous claims, **characterised in that** multiple conductive coils (3a₁, 3a₂, 3a₃, 3a₄) are arranged on corresponding multiple coil surfaces (21, 22, 25a, 25b) at a same coil region (2a).

5. Current detection device, according to claim 4, **characterised in that** said multiple coil surfaces (21, 22, 25a, 25b) at a same coil region (2a) include at least an internal surface (25a, 25b) of said support board.

6. Current detection device, according to one of the previous claims, **characterised in that** each conductive coil (3a, 3b, 3c, 3d) is formed by at least a coil turn (30) spirally wound around a coil axis (30a, 30b, 30c, 30d) perpendicular to said support board.

7. Current detection device, according to one of the previous claims, **characterised in that** each conductive coil (3a, 3b, 3c, 3d) is formed by at least a conductive route (300) deposited on said coil surface (21, 22, 25) of said support board (2) by means of printed circuit technologies.

8. Current detection device, according to one of the previous claims, **characterised in that** each magnetic element (4a, 4b, 4c, 4d) is shaped in such a way to surround partially the passage (20) through said support board at a surface (21, 22) of said support board.

9. Current detection device, according to one of the previous claims, **characterised in that** the coil regions (2a, 2b, 2c, 2d) of said support board are arranged at symmetric positions relative to the passage (20) through said support board.

10. Current detection device, according to one of the previous claims, **characterised in that** each magnetic element (4a, 4b, 4c, 4d) is formed by at least a plate made of a ferromagnetic material.

11. Current detection device, according to claim 10, **characterised in that** each magnetic element is formed by a stack of contoured plates made of a ferromagnetic material.

12. Current detection device, according to claim 10, **characterised in that** each magnetic element is formed by a single contoured plate made of a ferromagnetic material.

13. Current detection device, according to one of the previous claims, **characterised in that** said magnetic circuit (4) comprises:
- first and second conductive coils (3a, 3b) arranged on said support board (2) at first and second coil regions (2a, 2b) of said support board, respectively;
- first and second magnetic elements (4a, 4b) arranged at the first and second surfaces (21, 22) of the support board, respectively,
wherein said first and second magnetic elements (4a, 4b) are mutually overlapped at the first and second coil regions (2a, 2b) of said support board,
wherein the overlapped first and second magnetic elements (4a, 4b) at the first coil region (2a) of said support board are spaced apart one from another and define a first airgap (40a) of said magnetic circuit, in which said first conductive coil (3a) is placed,
wherein the overlapped first and second magnetic elements (4a, 4b) at the second coil region (2b) of said support board are spaced apart one from another and define a second airgap (40b) of said magnetic circuit, in which said second conductive coil (3b) is placed.

14. Current detection device, according to one of the claims from 1 to 12, **characterised in that** said magnetic circuit (4) comprises:
- first, second, third and fourth conductive coils (3a, 3b, 3c, 3d) arranged on said support board (2) at first, second, third and fourth coil regions (2a, 2b, 2c, 2d) of said support board, respectively;
- first and second magnetic elements (4a, 4b) arranged at the first surface (21) of the support board and third and fourth magnetic elements (4c, 4d) arranged at the second surface (22) of the support board,
wherein said first magnetic element (4a) is overlapped with said third and fourth magnetic elements (4c, 4d) at the first and fourth coil regions (2a, 2d) of said support board, respectively,
wherein said second magnetic element (4b) is overlapped with said third and fourth magnetic elements (4c, 4d) at the second and third coil regions (2b, 2c) of said support board, respectively,
wherein the overlapped first and third magnetic elements (4a, 4c) at the first coil region (2a) of said support board are spaced apart one from another and define a first airgap (40a) of said magnetic circuit, in which said first conductive coil (3a) is placed,
wherein the overlapped second and third magnetic elements (4b, 4c) at the second coil region (2b) of said support board are spaced apart one from another and define a second airgap (40b) of said magnetic circuit, in which said second conductive coil (3b) is placed,
wherein the overlapped second and fourth magnetic elements (4b, 4d) at the third coil region (2c) of said support board are spaced apart one from another and define a third airgap (40c) of said magnetic circuit, in which said third conductive coil (3c) is placed,
wherein the overlapped first and fourth magnetic elements (4a, 4d) at the fourth coil region (2d) of said support board are spaced apart one from another and define a fourth airgap (40d) of said magnetic circuit, in which said fourth conductive coil (3d) is placed.

15. A measurement unit (10), **characterized in that** it comprises a current detection device (1), according to one of the preceding claims.

16. Measurement unit, according to claim 15, **characterised in that** a signal processing device (6) is electrically connected to said conductive coils (3a, 3b, 3c, 3d) to receive and process detection signals indicative of a magnetic flux enchained with said conductive coils.

17. Measurement unit, according to claim 16, **characterised in that** said signal processing device (6) is arranged on the support board (2) of said current detection device (1).

18. A low-voltage electrical switchboard or electric line, **characterized in that** it comprises a measurement unit (10), according to one of the claims from 15 to 17.
